# EUROPEAN PATENT APPLICATION

(11) **EP 2 431 651 A2**
(43) Date of publication of application: **21.03.2012**
(21) Application number: 11007588.4
(22) Date of filing: 16.09.2011
(51) Int. Cl.: F21L 4/08, F21S 9/03

(54) **Portable light**

(30) Priority: 17.09.2010 JP 2010209368
(71) Applicant: Sanyo Electric Co., Ltd., Osaka 570-8677 (JP)
(72) Inventor: Toya, Shoichi, Moriguchi-shi Osaka 570-8677 (JP); Nakasho, Toshiki, Moriguchi-shi Osaka 570-8677 (JP)
(74) Representative: Beier, Ralph

(57) **Abstract**

The portable light is provided with an outer case 1, batteries 4 that can be charged and are housed inside the outer case 1, a solar panel 2 that charges the batteries 4, and a light source 3 illuminated by power from the batteries 4. The outer case 1 is provided with a flat-panel section 5 that contains the solar panel 2 and light source 3; and a battery compartment 6 that is thicker than the flat-panel section 5, is established protruding outward from the bottom edge of a flat-panel section 5 surface, and has a bottom standing surface 7 that enables the flat-panel section 5 to stand upright on its own.

## Description

### BACKGROUND OF THE INVENTION

### 1. Field of the Invention

The present invention relates to a portable light that charges internal batteries via a solar panel and illuminates a light source.

### 2. Description of the Related Art

A light, which charges internal batteries with solar cells to illuminate a light source, effectively utilizes renewable energy for illumination. A feature of this type of illumination is its handy use during recreational activities or during electrical outage due to a natural disaster such as an earthquake or storm. Portable illumination has been developed for use in these types of applications.

Refer to Japanese Laid-Open Patent Publication 2010-55789.

As shown in Fig. 1, the portable light cited in JP 2010-55789 has an outer case 91 housing batteries 94 that can be charged, a solar panel 92 that charges the batteries 94, and light source elements 93A that are illuminated by battery 94 power. The outer case 91 has an overall flat-panel shape with the solar panel 92 disposed on one side and a light source panel 93,which is a planar array of light source elements 93A, disposed on the other side. The solar panel 92 and the light source panel 93 are stacked together in parallel and housed in the outer case 91. Further, the portable light houses the batteries 94 in a section of the outer case 91 perimeter, and that section is configured as a grip 95 for carrying the portable light.

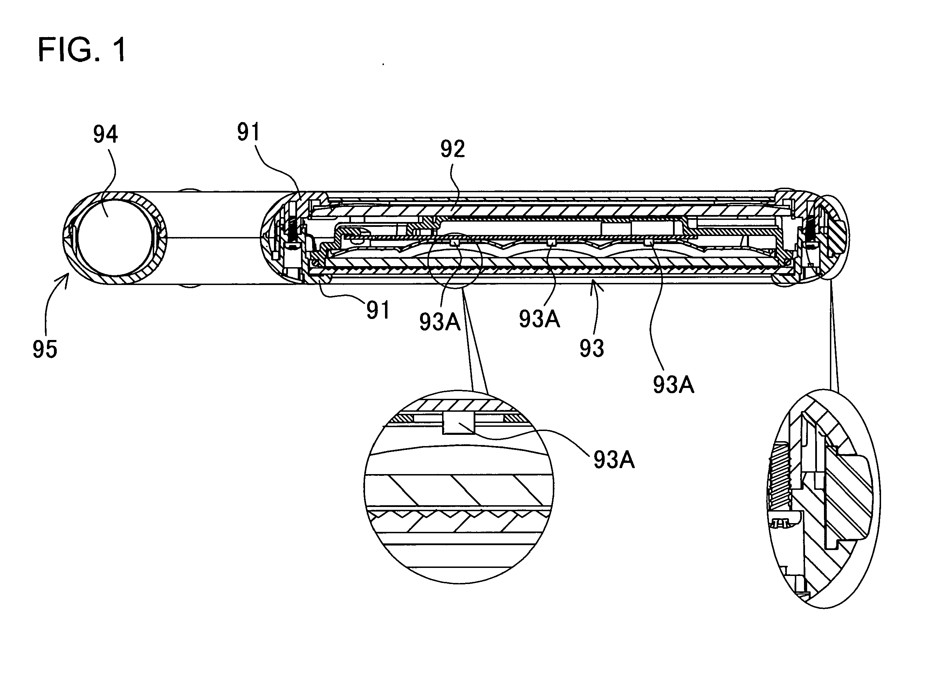

The portable light of Fig. 1 can reduce battery charging time by increasing the solar panel surface area and generated power, and can be conveniently carried by clasping the grip housing the batteries. However, this portable light has the drawback that it is not convenient to operate when charging the battery with the solar panel or when using it as a source of illumination. This is because the portable light cannot stand on its own in a stable manner, and standing the light for solar panel battery charging or illumination is troublesome. It has the further drawback that when both sides are sandwiched by objects to hold the light upright, those objects reduce the effective surface area of the solar panel or reduce the light source illumination area preventing the light from shining brightly.

The present invention was developed to resolve these drawbacks. Thus, it is a primary object of the present invention to provide a portable light that can stand on its own in a stable manner to increase solar panel surface area and power generation, and increase light source illumination area allowing it to shine brightly. It is another important object of the present invention to provide a portable light that can stand stably on its own while the surface area of the solar panel and light source is increased.

### SUMMARY OF THE INVENTION

The portable light of the present invention is provided with an outer case 1, batteries 4 that can be charged and are housed inside the outer case 1, a solar panel 2 that charges the batteries 4, and a light source 3 illuminated by power from the batteries 4. The outer case 1 is provided with a flat-panel section 5 that contains the solar panel 2 and light source 3, and a battery compartment 6 that is thicker than the flat-panel section 5, is established projecting outward from the bottom edge of a surface of the flat-panel section 5, and has a bottom standing surface 7 enabling the portable light to stand alone.

The portable light described above has the characteristic that it can stand alone in a stable manner to increase solar panel surface area and power generation, and increase light source illumination area allowing it to shine brightly. Further, as a result of a low center-of-gravity due to the heavy batteries and the standing surface projecting outward from the front surface of the flat-panel section, the portable light has the characteristic that it can stand stably on its own while the surface area of the solar panel and light source is increased.

In the portable light of the present invention, the standing surface 7 can stand the flat-panel section 5 with the solar panel 2 surface inclined at an angle greater than a right angle with respect to horizontal and the light source 3 surface inclined at an angle less than a right angle with respect to horizontal. This portable light has the characteristic that solar panel output can be increased to efficiently charge the batteries, and the light source can shine brightly. This is because the solar panel is disposed facing upward and the light source is disposed pointing downward.

The portable light of the present invention can be provided with a circuit board 10 housed inside the flat-panel section 5. Solar cells 20 that make up the solar panel 2 can be disposed on a first surface 11 of the circuit board 10, and the light source 3 can be disposed on a second surface 12 on the opposite side of the circuit board 10. Further, the first surface 11 and the second surface 12 of the circuit board 10 can be laminated in a water-tight configuration with light-transparent film layers 8 and housed in the outer case 1. In this portable light, the flat-panel section can be made thin by mounting the solar panel and light source on a single circuit board while both the solar panel and light source can be reliably sealed in a water-tight structure by laminating both sides of the circuit board with light-transparent film layers. Accordingly, the solar panel and light source can be configured in an ideal water-tight manner without requiring the outer case to be a completely water-tight structure.

In the portable light of the present invention, the light-transparent film layers 8 can be laminated on the circuit board 10 in a manner establishing exposed regions 13 around the perimeter on both sides, and the exposed regions 13 can be sandwiched by the outer case 1 to hold the circuit board 10 in a fixed position inside the outer case 1. This portable light can reliably dispose the circuit board in a fixed position in the outer case. This is because the exposed regions with no light-transparent film are sandwiched between the outer case and held in fixed positions. A circuit board laminated on both sides with light-transparent film layers achieves an ideal water-tight configuration by virtue of the light-transparent film layers. However, since there is inconsistency in the film thickness of the light-transparent layers, it is difficult to hold the laminated circuit board accurately in a fixed position in the outer case. The portable light described above has exposed regions established around the outside of the circuit board where no light-transparent film is laminated, and those exposed regions are held on both sides by the outer case to fix the circuit board in a given position. Further, since all areas of the circuit board other than the perimeter regions are laminated with light-transparent film, a water-tight structure is achieved over essentially the entire circuit board.

In the portable light of the present invention, sections of the perimeter of the circuit board 10 can be provided with escape regions 8X that allow the light-transparent film layers 8 to extend beyond the outer edge of the circuit board 10. ln this portable light, the light-transparent film can laminate the surfaces of the circuit board in an ideal water-tight structure. This is because both sides of the circuit board are covered with light-transparent film layers that are melted and adhered onto the surfaces of the circuit board in a laminating step, and during that step, lamination can proceed while flowing out excess heat-softened light-transparent film to the outside through the escape regions.

In the portable light of the present invention, the light-transparent film layers 8 can be ethylene vinyl acetate (EVA). This portable light has the characteristic that the surfaces of the circuit board can configured in a preferred water-tight manner while increasing the power generating efficiency of the solar panel and allowing the light source to shine brightly. This is because EVA light-transparent film has superior light transmittance, and can be melted and adhered to the circuit board surfaces to form a water-tight structure.

In the portable light of the present invention, a light source 3 of light emitting diodes (LEDs) 3A and electronic components 36 can be mounted on the second surface 12 of the circuit board 10, and the LEDs 3A and electronic components 36 can be laminated with light-transparent film 8 to form a water-tight structure. This portable light has the characteristic that the light-transparent film can establish an ideal water-tight structure for both the LEDs and the electronic components mounted on the circuit board surface. The above and further objects of the present invention as well as the features thereof will become more apparent from the following detailed description to be made in conjunction with the accompanying drawings.

### BRIEF DESCRIPTION OF THE DRAWINGS

Fig. 1 is a cross-section view of a prior-art portable light;
Fig. 2 is an oblique view of a portable light for an embodiment of the present invention;
Fig. 3 is an oblique view from behind of the portable light shown in Fig. 2;
Fig. 4 is an exploded oblique view of the portable light shown in Fig. 2;
Fig. 5 is an exploded oblique view of the portable light shown in Fig. 2;
Fig. 6 is a vertical cross-section view of the portable light shown in Fig. 2;
Fig. 7 is a cross-section through the line VII-VII in the portable light shown in Fig. 6;
Fig. 8 is a side view of the portable light shown in Fig. 2;
Fig. 9 is a side view showing another orientation for using the portable light in an embodiment of the present invention;
Fig. 10 is an exploded oblique view showing the circuit board light-transparent film layers;
Fig. 11 is an oblique view from behind of the circuit board light-transparent film layers shown in Fig. 10;
Fig. 12 is a front view showing light-transparent film layers established on the circuit board;
Fig. 13 is a rear view of the circuit board and light-transparent film layers shown in Fig. 12;
Fig. 14 is an abbreviated cross-section view showing the processing step that laminates the circuit board with light-transparent film layers, and corresponds to a cross-section through the line XIV-XIV of Fig. 16;
Fig. 15 is an abbreviated cross-section view showing the processing step that laminates the circuit board with light-transparent film layers, and corresponds to a cross-section through the line XV-XV of Fig. 16;
Fig. 16 is a horizontal cross-section view showing the processing step that laminates the circuit board with light-transparent film layers, and corresponds to a cross-section through the line XVI-XVI of Fig. 14;
Fig. 17 is a horizontal cross-section view showing the processing step that laminates the circuit board with light-transparent film layers, and corresponds to a cross-section through the line XVII-XVII of Fig. 14;
Fig. 18 is an enlarged oblique view showing an example of a light-transparent plate; and
Fig. 19 is a block diagram of a portable light for an embodiment of the present invention.

### DETAILED DESCRIPTION OF THE EMBODIMENTS

The following describes embodiments of the present invention based on the figures. However, the following embodiments are merely specific examples of a portable light representative of the technology associated with the present invention, and the portable light of the present invention is not limited to the embodiments described below. Further, components indicated in the appended claims are in no way limited to the components indicated in the embodiments.

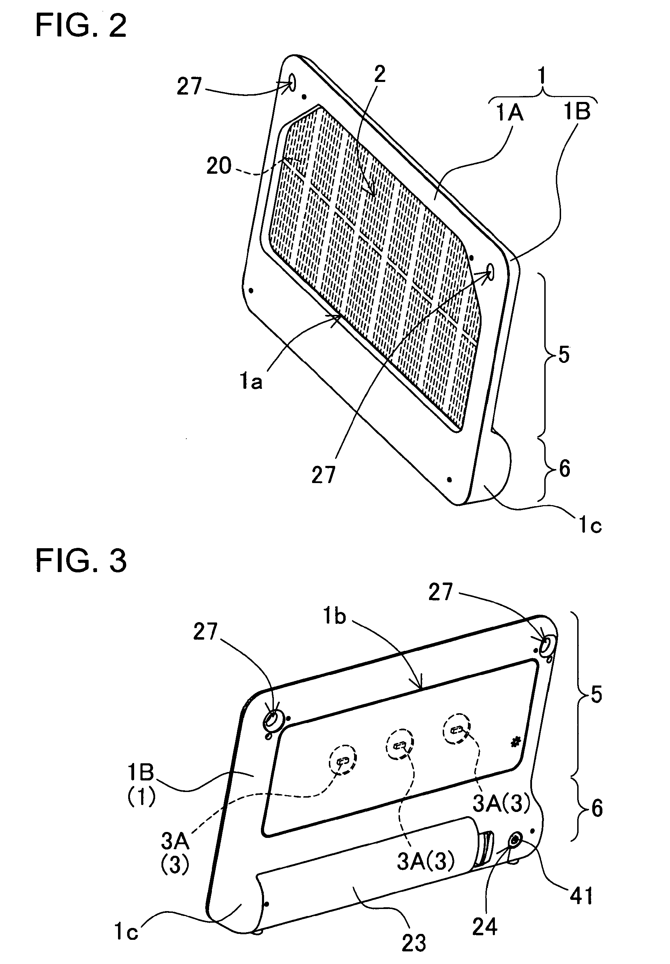

The portable light shown in Figs. 2-9 is provided with an outer case 1, batteries 4 that can be charged and are housed inside the outer case 1, a solar panel 2 that charges the batteries 4, and a light source 3 illuminated by power from the batteries 4.

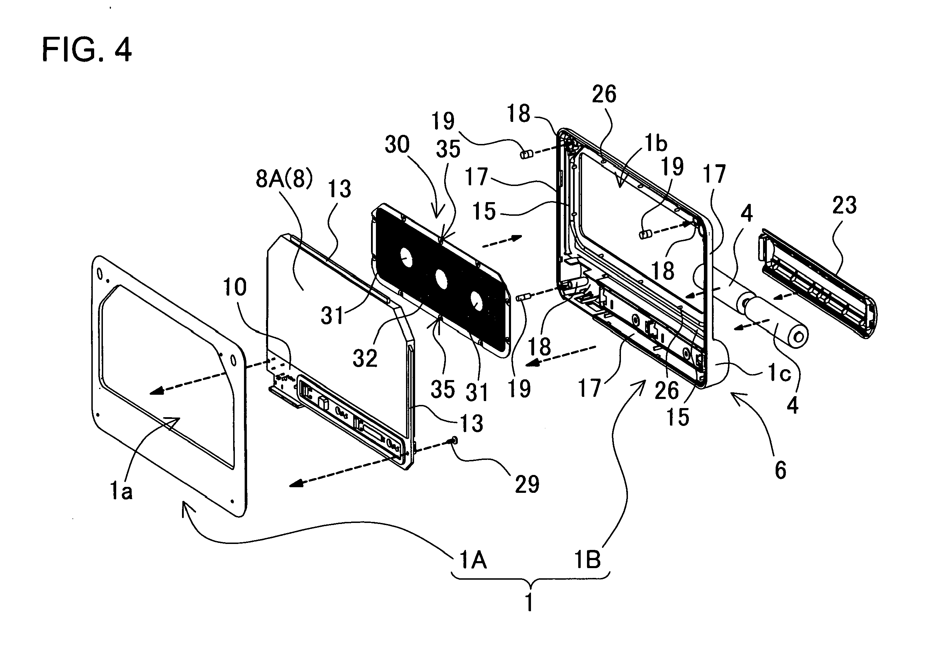

As shown in Figs. 4-7, the outer case 1 is made up of a first case 1A and a second case 1 B, and the solar panel 2 and light source 3 are disposed inside the first case 1A and second case 1B. The outer case 1 is made of plastic and is divided in the thickness direction into the first case 1A and the second case 1 B. The first case 1A and the second case 1 B are shaped to connect opposing perimeter edges and close off the interior. Perimeter walls 17 established around the outside of the second case 1 B mate with perimeter edges around the first case 1A to connect the first and second cases 1A, 1 B of the outer case 1 in the figures. Further, connecting cylinders 18 are established protruding from opposing inner surfaces of the first case 1A and the second case 1 B, and the outer case 1 is connected by inserting assembly rods 19 into the connecting cylinders 18. Both ends of the assembly rods 19 are bonded into connecting cylinders 18 to join the first case 1A and the second case 1B in a manner that does not come apart. However, the first and the second cases can also be connected with set screws that pass through one side and screw into bosses established in the other side, or can also be connected by a snap-together configuration. The outer case 1 of the figures has an overall rectangular shape.

The outer case 1 is provided with a flat-panel section 5 that contains the solar panel 2 and light source 3, and a battery compartment 6 that is thicker than the flat-panel section 5 and is established projecting outward from the bottom edge of a surface of the flat-panel section 5. In this outer case 1, the battery compartment 6 that hold the batteries 4 is established along the bottom edge of the flat-panel section 5 that holds the solar panel 2 and light source 3. In the outer case 1 of the figures, the first case 1A and the second case 1B are joined together to form the flat-panel section 5 and the battery compartment 6. The first case 1A has an overall flat rectangular shape and has a window 1 a opened to expose the solar panel 2. The second case 1B has an overall rectangular shape, has a window 1 b opened to emit light from the light source 3, and has a widened section 1 c projecting out the backside along the rectangular bottom edge. The flat-panel section 5 of the outer case 1 is formed by joining perimeter edges around the first case 1A window 1a except along the bottom edge with perimeter edges around the second case 1B window 1 b except along the bottom edge. The battery compartment 6 of the outer case 1 is formed by joining perimeter edges around the bottom section of the first case 1A with perimeter edges around the widened section 1 c of the second case 1B.

The flat-panel section 5 houses the solar panel 2 and light source 3. The solar panel 2 is disposed in the window 1a of the first case 1A, and the light source 3 is disposed in the window 1 b of the second case 1B. The window 1a of the first case 1A shown in the figures is shaped as a rectangle with truncated corners in the upper half forming a six-sided figure, and a solar panel 2 that conforms to the shape of the window 1a is disposed in a manner that exposes the solar panel 2 through the window 1 a. The second case 1 B has a rectangular window 1 b, and the light source 3 is housed in the center region of the window 1 b. The flat-panel section 5 houses a circuit board 10 mounted in a fixed position. The circuit board 10 is a printed circuit board with an outline essentially the same shape as the interior of the flat-panel section 5 of the outer case 1. The circuit board 10 holds the solar panel 2 on a first surface 11, which is on the side of the first case 1A, and holds the light source 3 on a second surface 12, which is on the opposite side of the circuit board 10.

The solar panel 2 is made up of a plurality of solar cells 20 mounted on the first surface 11 of the circuit board 10. The solar panel 2 generates power from solar energy shining through the window 1a in the first case 1A to charge the internal batteries 4. By enlarging the surface area of the solar panel 2, high capacity batteries 4 can be charged rapidly. If the rectangular outer case 1 has a side that is 15cm to 25cm in length, a solar panel 2 can be installed that has a specified output of 2W to 3W.

The light source 3 is made up of LEDs 3A mounted on the second surface 12 of the circuit board 10. The light source 3 of the figures is a plurality of white-light LEDs 3A mounted on the circuit board 10. The light source 3 of the figures has three equally-spaced chip-type LEDs 3A mounted laterally in a row in the center region of the window 1 b. However, the light source can also have a plurality of LEDs mounted in an array extending horizontally and vertically. Chip-type LEDs 3A do not focus the emitted light, but rather shine it uniformly over a wide angle. A light source 3 of LEDs 3A can shine brightly with little battery 4 power consumption and can emit light for an extended time period. For example, using the internal batteries 4 described later and powering three LEDs 3A, the light source 3 can be illuminated for approximately 16hrs. Approximately 45hrs of illumination can be obtained powering one LED. In addition to the LEDs 3A, a plurality of electronic components 36 are also mounted on the second surface 12 of the circuit board 10.

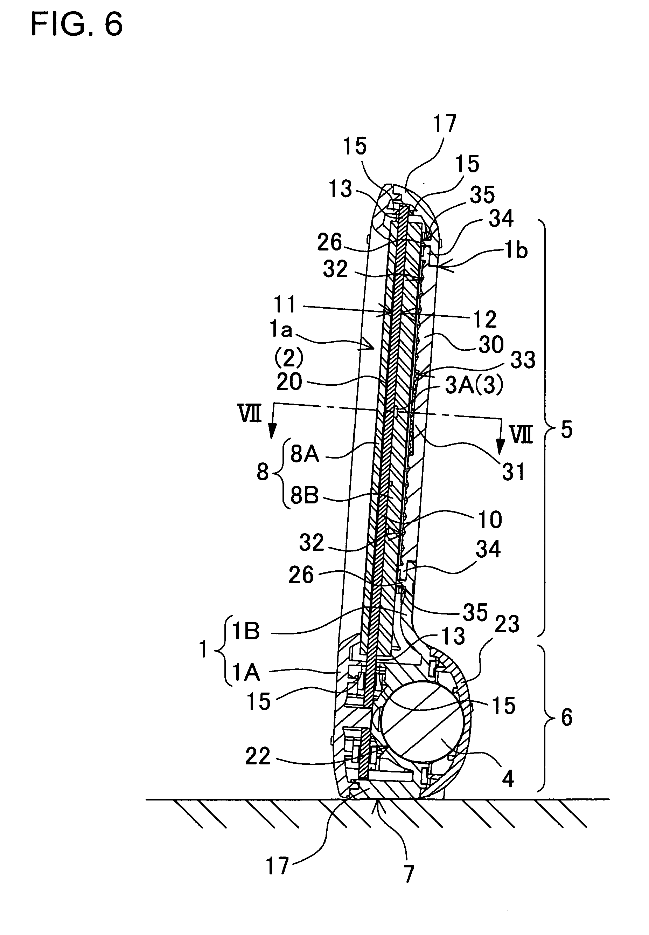

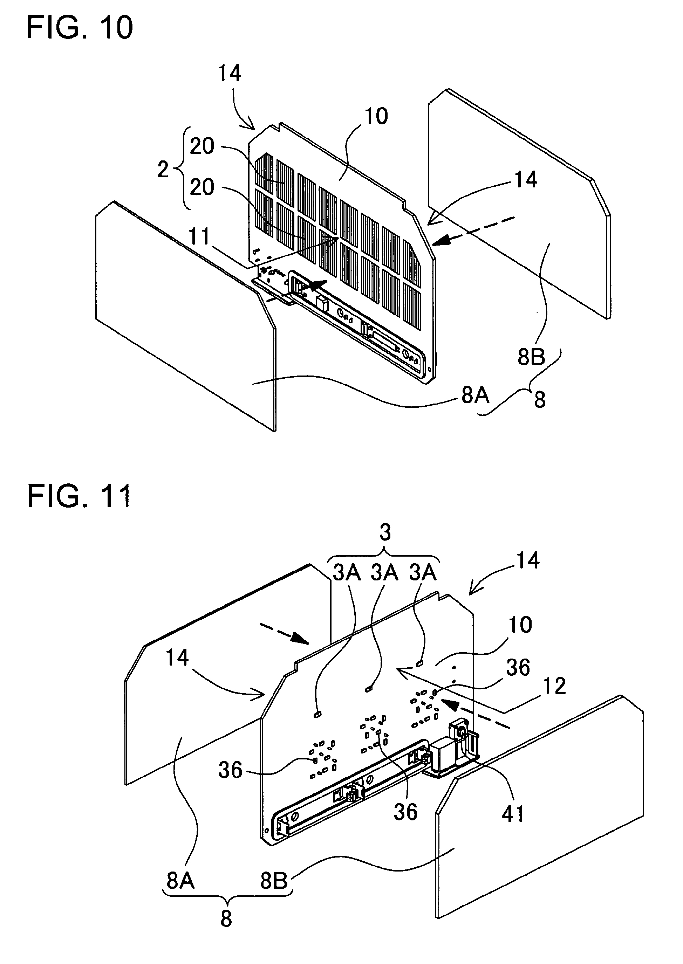

As shown in Figs. 6, 7, and 10-13, the circuit board 10 is made water-tight by establishing light-transparent film layers 8 on the first surface 11 where solar cells 20 are disposed and on the second surface 12 where light source 3 LEDs 3A and electronic components 36 are disposed. Specifically, both sides of the circuit board 10 are laminated with light-transparent film layers 8 to form a water-tight structure. Ethylene vinyl acetate (EVA) is most appropriate as a light-transparent film layer 8. This is because EVA has superior light transmittance and can be easily melted and adhered as a hermetic covering that forms a water-tight structure. However, other plastic films that can be thermally adhered can also be used as the light-transparent film layers. In addition, the light-transparent film layers can include other plastic film layers laminated with the EVA layers. For example, a light-transparent film layer can be a multiple-layer structure with a polyethylene-telephthalate (PET) layer laminated on the surface of an EVA layer. This type of light-transparent film structure can protect the surface with the PET layer while taking advantage of the superior adhesion and water-resistance of the EVA layer.

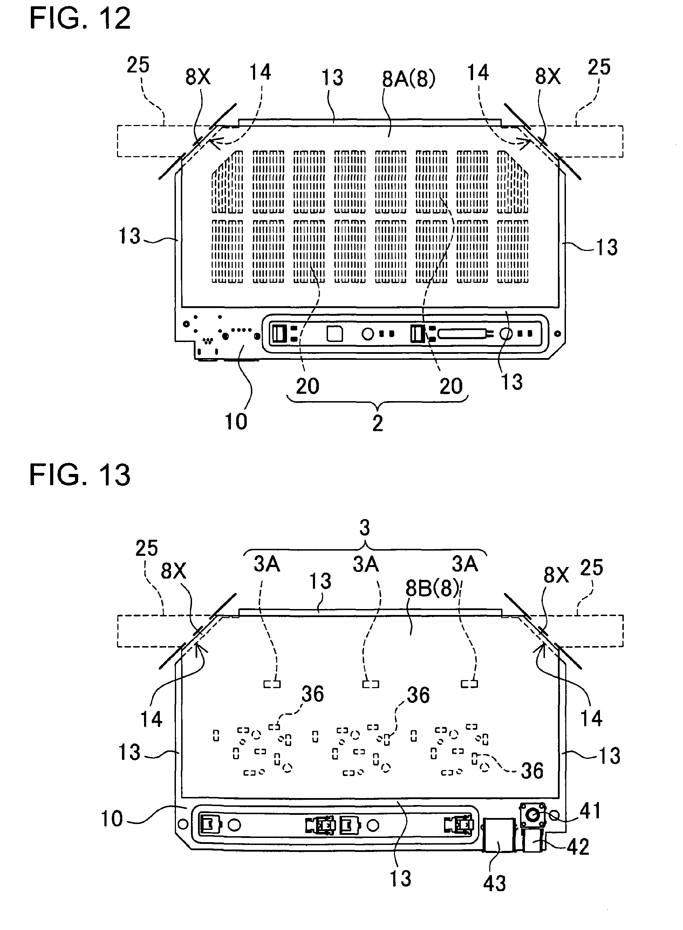

As shown in Figs. 12 and 13, light-transparent film layers 8 are not laminated in a manner that entirely covers all the surfaces of the circuit board 10, but rather the laminating process establishes exposed regions 13 around the perimeter of the circuit board 10. The circuit board 10 shown in the figures has an overall rectangular shape with corner cuts 14 that truncate the corners on both sides of the top of the figures. Exposed regions 13 with no light-transparent film 8 lamination are established in the perimeter regions of the circuit board 10 except at the corner cuts 14. Further, escape regions 8X are provided where during the lamination processing step melted light-transparent film layers 8 extend to the outer edge of the circuit board 10 on both sides. The escape regions 8X for molten light-transparent film layers 8 in the figures are provided in the circuit board 10 corner cuts 14. Escape regions 8X extend to the outer edges of the corner cuts 14 on both the first surface 11 and the second surface 12 of the circuit board 10, and light-transparent film layers 8 adhere together in the melted state and merge together as a single layer at the edges of the circuit board 10. Specifically, the light-transparent film layer 8A laminating the first surface 11 of the circuit board 10 and the light-transparent film layer 8B laminating the second surface 12 merge together at the corner cuts 14 enabling formation of light-transparent film layers 8 that adhere to both sides of the circuit board 10.

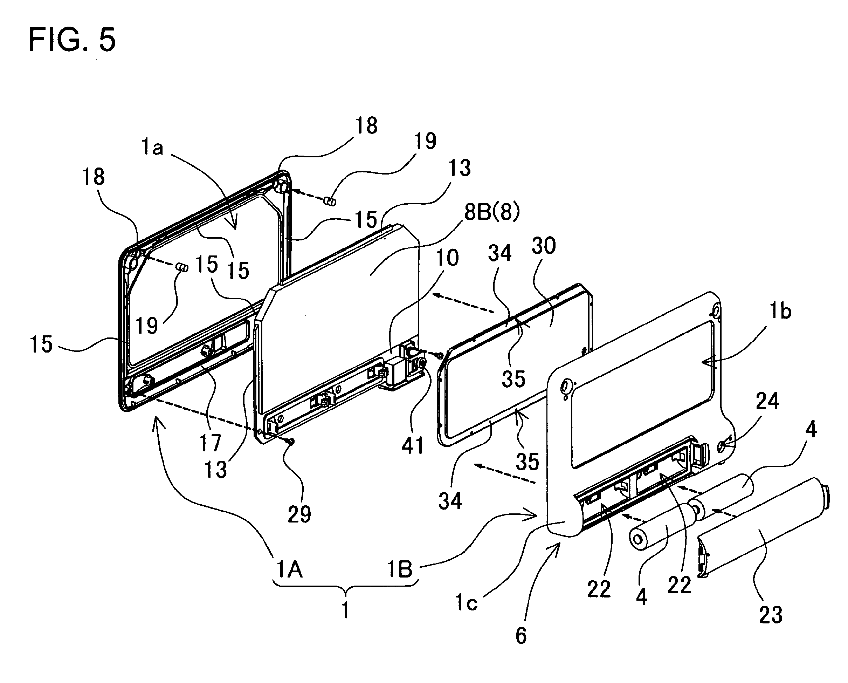

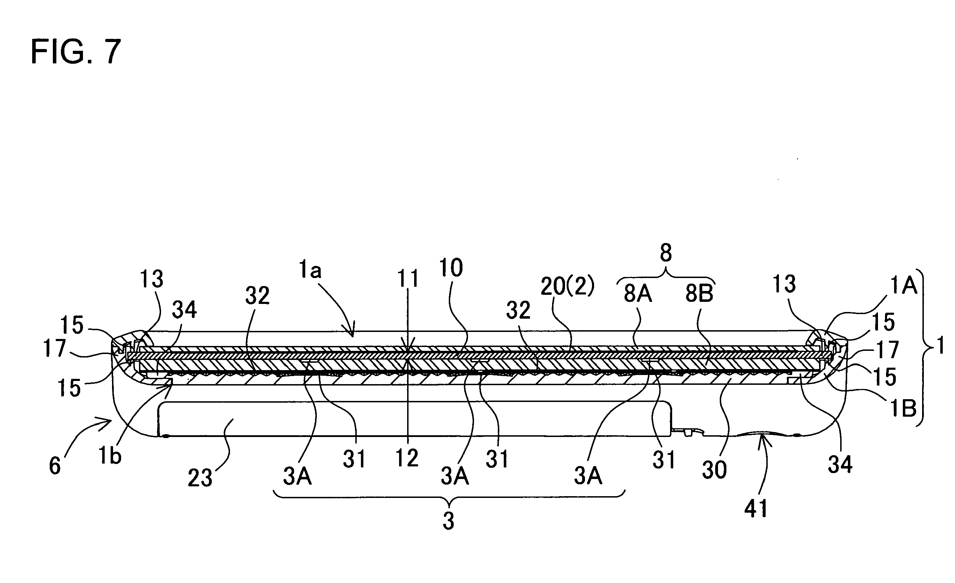

This circuit board 10 can be reliably held in a fixed position in the outer case 1 by sandwiching the exposed regions 13 established around the perimeter of the circuit board 10 inside the outer case 1. Here, if the circuit board was laminated entirely on both sides with light-transparent film, it would be difficult to sandwich the circuit board in an accurate fixed position inside the outer case because of thickness inconsistencies in the light-transparent film layers. In contrast, the circuit board 10 described above is retained by sandwiching exposed regions 13 with no light-transparent film layers 8 between the outer case 1 components. Specifically, the circuit board 10 described above can be reliably held in a fixed position in the outer case 1 because perimeter regions of the bare circuit board 10 with no thickness variation are sandwiched between the outer case 1 components. As shown in Figs. 4 and 5, the circuit board 10 is attached in a fixed position in the first case 1A by screwing set screws 29 that pass through the circuit board 10 into the first case 1A. As shown in Figs. 6 and 7, the exposed regions 13 of the circuit board 10 attached in this manner are sandwiched between support ribs 15 established around the perimeter edges of the first case 1A and the second case 1 B to retain the circuit board 10 in a fixed position inside the outer case 1. The outer case 1 shown in the figures is provided with opposing support ribs 15 on the inside surfaces of the first case 1A and the second case 1 B that are positioned corresponding to the exposed regions 13 established on the front and back of four sides of the circuit board 10. The first case 1A and the second case 1 B sandwich the exposed regions 13 on the four sides of the circuit board 10 between opposing support ribs 15 to reliably retain the circuit board 10 in a fixed position.

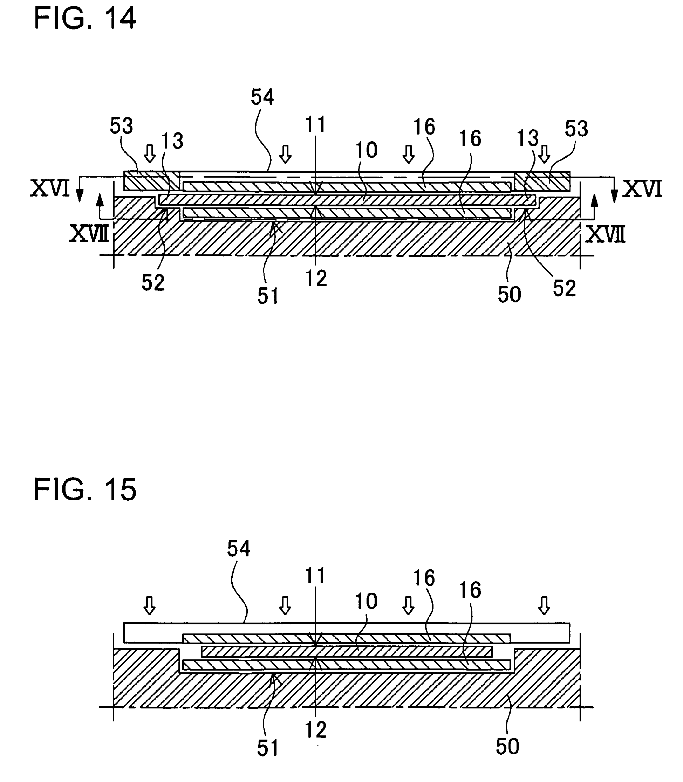

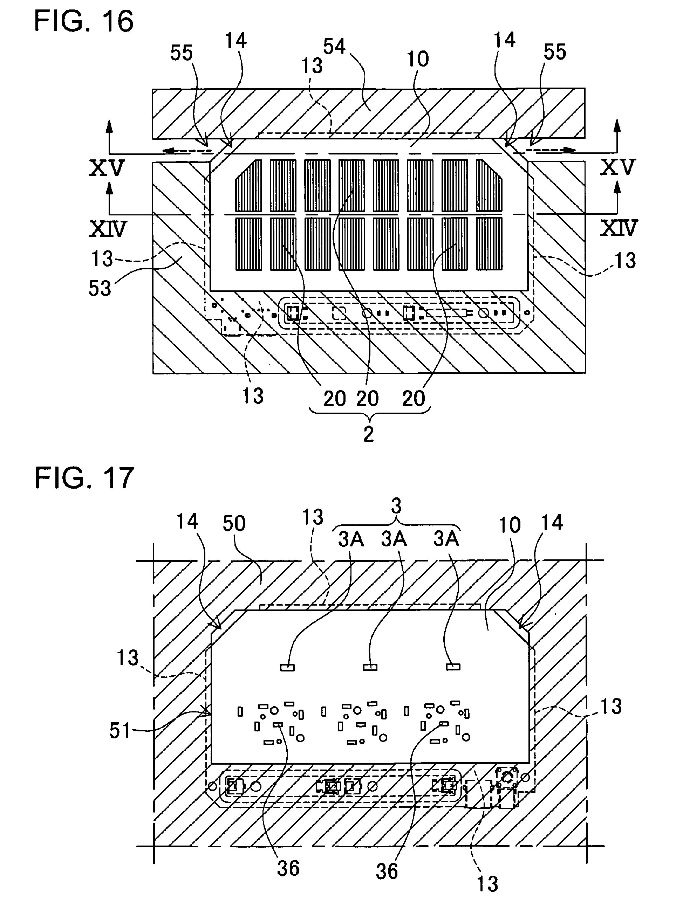

The first surface 11 and second surface 12 of the circuit board 10 are laminated with light-transparent film layers 8 by the following process steps.
(1) As shown in the abbreviated cross-section views of Figs. 14 and 15, EVA film 16 to laminate the second surface 12 of the circuit board 10 is disposed in the bottom of a cavity 51 in an assembly tool (jig) 50.
(2) The circuit board 10 is placed on the top of the cavity 51 in the assembly tool 50 with the second surface 12 facing downward. As shown in Fig. 14, circuit board 10 perimeter edges, where exposed regions 13 are formed, are disposed on top of a step 52 established around the outer edge of the cavity 51 in the assembly tool 50.
(3) A first masking plate 53 and a second masking plate 54 are disposed on top of the circuit board 10 set in the assembly tool 50. The first masking plate 53 covers three sides of the circuit board 10 and masks the three sides that include the corners with no corner cuts 14 to form exposed regions 13 in those areas. The second masking plate 54 masks the circuit board 10 edge along the line joining the corner cuts 14 and forms an exposed region 13 in that area. With this arrangement, gaps 55 with no masking are formed in the circuit board 10 corner cut 14 regions between the top of the U-shaped first masking plate 54 and the second masking plate 54.
(4) As shown in the abbreviated cross-section views of Figs. 14 and 15, EVA film 16 to laminate the first surface 11 of the circuit board 10 is disposed on top of the first surface 11 of the circuit board 10.
(5) A laminating tool (not illustrated) applies heat and melts the EVA film 16 layers above and below the circuit board 10, and applies a vacuum to tightly adhere the molten EVA to the surfaces of the circuit board 10 and form light-transparent film layers 8A, 8B of uniform thickness over both sides of the circuit board 10.
(6) As shown in Figs. 16 and 17, some of the molten EVA extends over the outer edges of the circuit board 10 at the corner cuts 14 to form the escape regions 8X. Further, molten EVA flows out through the gaps 55 between the first masking plate 53 and the second masking plate 54 as excess 25.
(7) EVA in the escape regions 8X extends over the circuit board 10 edges from both sides and merges together at the corner cuts 14 to connect the light-transparent film layers 8A, 8B formed on both sides of the circuit board 10 at the corner cuts 14.
(8) As shown in Figs. 12 and 13, the circuit board 10 laminated on both sides is removed from the assembly tool 50 and the excess 25 EVA extending from the corner cuts 14 is trimmed off at the bold broken lines shown in the figures.

In the portable light described above, the solar panel 2 and light source 3 are mounted on a single circuit board 10 making the flat-panel section 5 thin while reliably configuring both the solar panel 2 and the light source 3 as water-tight structures by laminating both sides of the circuit board 10 with light-transparent film layers 8. Accordingly, the solar panel 2 and light source 3 can be configured in an ideal water-tight manner without making the outer case a completely water-tight structure.

The battery compartment 6 is established along the bottom of the flat-panel section 5 and is formed thicker than the flat-panel section 5 to hold batteries 4 inside. As shown in Fig. 6, the bottom of the second case 1B protrudes out from the second surface 12 of the circuit board 10 to provide room to hold batteries 4 in the battery compartment 6. The bottom surface of the battery compartment 6 is established as a flat standing surface 7 that stands the flat-panel section 5 upright and allows the portable light to stand on its own. The battery compartment 6 standing surface 7 can be made wide to hold the flat-panel section 5 in a stable upright position. However, if the standing surface is widened, the battery compartment becomes larger and cannot be made as a compact structure. Accordingly, the battery compartment 6 standing surface 7 is made an optimum size considering these trade-offs. To maintain the flat-panel section 5 in a stable upright position, the battery compartment 6 shown in the figures is provided with supporting tabs 21 that extend rearward from the standing surface 7 on both sides. This battery compartment 6 can hold the flat-panel section 5 in a stable upright position with the supporting tabs 21 in contact with the floor or other supporting surface while reducing the size of the standing surface 7. This portable light has a low center-of-gravity by virtue of the heavy batteries 4 housed in the battery compartment 6, and can stably stand alone with the flat-panel section 5 upright.

The battery compartment 6 is provided with a battery insertion section 22 where batteries 4 are loaded in a removable manner. The battery compartment 6 of the figures has the battery insertion section 22 established on the second surface 12 side of the circuit board 10, and a cover 23 is attached in a detachable manner to close-off the battery insertion section 22. Rechargeable batteries 4, which are circular cylindrical batteries, are loaded in the battery insertion section 22 of the battery compartment 6. The portable light of Figs. 4 and 5 houses two circular cylindrical nickel-hydride battery cells in a straight-line row inside the battery insertion section 22 of the battery compartment 6. The batteries 4, which are two nickel-hydride battery cells, have a full-charge capacity of 2000mAh to 5000mAh, and preferably have a full-charge capacity of 3200mAh.

The portable light of the figures is also provided with a light switch 41 in the end region on the backside of the battery compartment 6. The light switch 41 is a push-button switch housed in the battery compartment 6 that is operated by pressing the push-button exposed through a switch window 24 opened through the battery compartment 6.

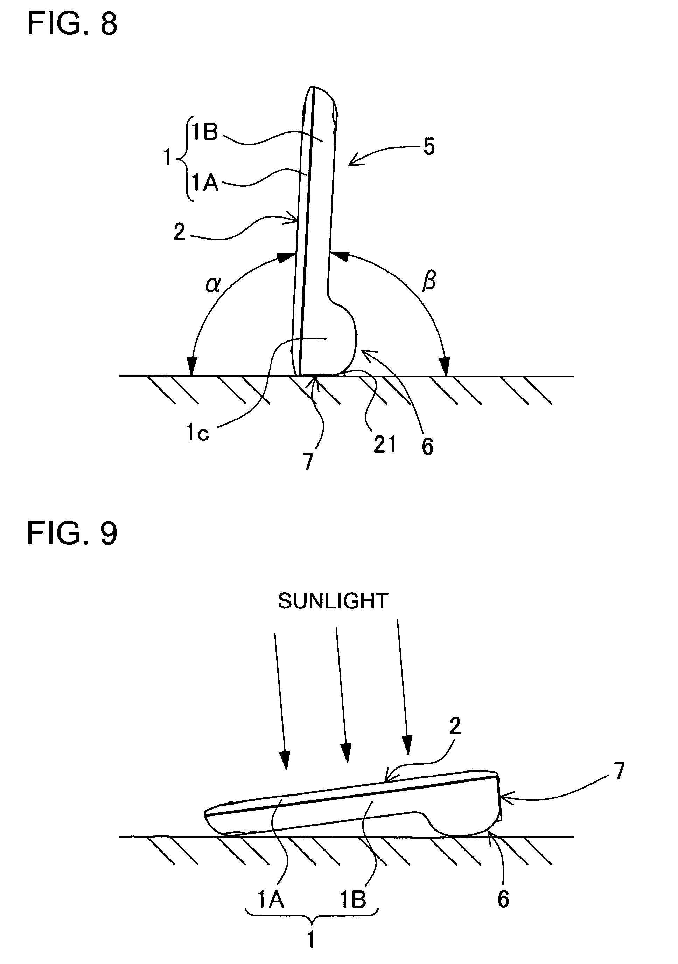

With batteries loaded in the battery compartment 6, the portable light described above stands on its own with the flat-panel section 5 upright when the battery compartment 6 standing surface 7 is the bottom surface placed on the floor or other supporting surface. As shown in Fig. 8, the standing surface 7 of the battery compartment 6 is formed in a manner that stands the flat-panel section 5 with the solar panel 2 surface at an angle (α) greater than a right angle with respect to horizontal and the light source 3 surface at an angle (β) less than a right angle with respect to horizontal. Since this portable light disposes the upright flat-panel section 5 with the solar panel 2 facing upward and the light source pointing downward, it has the characteristic that solar panel 2 output can be increased to efficiently charge the batteries 4 and the light source 2 can shine brightly.

Further, the portable light of the present invention can be positioned in the orientation shown in Fig. 9 to effectively collect sunlight shining from directly above and efficiently charge the batteries 4. Since the flat-panel section 5 of this portable light is maintained at a slight incline by the battery compartment 6, it can lie stably for battery charging over a long period. In particular, near noon in summer or in low latitude locations when the elevation angle of the sun (solar culmination) is close to 90°, this orientation can efficiently collect sunlight for battery charging.

The portable light shown in Figs. 5-7 has a transparent plate 30 disposed on the surface of the light-transparent film layer 8B established on the second surface 12 of the circuit board 10, which is the light source 3 side of the circuit board 10. This transparent plate 30 is shaped to fit in the window 1 b of the second case 1 B. The transparent plate 30 is a plate with light transmitting properties that can pass light from the light source 3, and is, for example, an acrylic plastic plate.

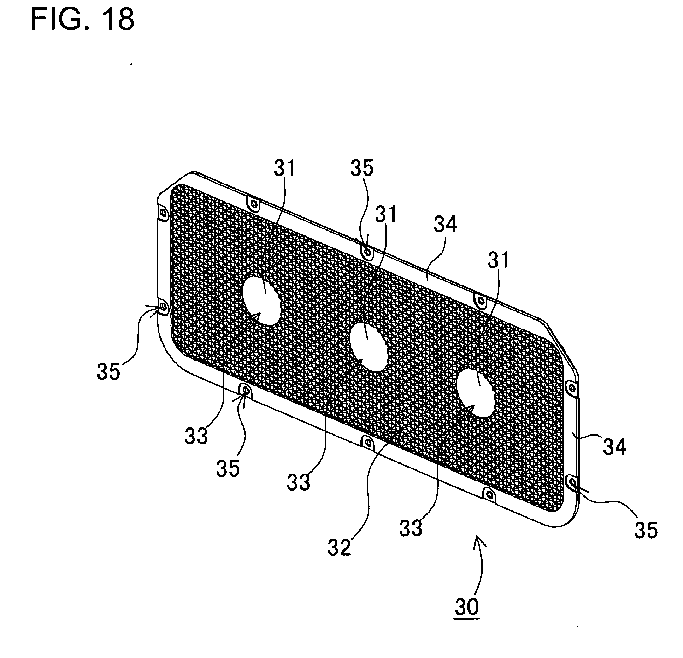

As shown in Fig. 18, the transparent plate 30 is provided with light converging regions 31 that converge and transmit light emitted from the light source 3, and a diffusing region 32 that scatters and transmits light emitted from the light source 3. The transparent plate 30 of the figures has the converging regions 31 and diffusing region 32 formed as an indented surface on the circuit board 10 side, which is the side facing the light-transparent film layer 8, and has the opposite outward facing surface formed as a smooth surface. Since this transparent plate 30 has its smooth surface exposed from the outer case 1, it can shine transmitted light while preventing dust and dirt from collecting on the surface.

The converging regions 31 are circular depressions 33 provided in locations opposite the light source 3 elements mounted on the circuit board 10 and have protruding center regions inside the depressions 33 that form optical lens shapes. These converging regions 31 converge light emitted from the light source 3 and shine it outward. In particular, since the light source 3 elements are chip-type LEDs 3A, the converging regions 31 condense the light emitted over a wide angle allowing it to shine more intensely to the outside.

The diffusing region 32 is established on the circuit board 10 side of the transparent plate 30 over essentially the entire surface except in the converging regions 31. The diffusing region 32 is a dimpled surface illuminated by light emitted in a wide angle by the chip-type LEDs 3A. The diffusing region 32 scatters light not condensed by the converging regions 31 to shine light uniformly over a wider area. The dimpled surface of the diffusing region 32 shown in Fig. 18 is many square-based pyramid indentations formed regularly in oblique rows aligned in the diagonal direction of the figure. In this diffusing region 32, light incident on the dimpled surface is refracted and diffused in various directions and emitted from the outer smooth surface as uniform illumination. In particular, unfocused light emitted over a wide angle by chip-type LEDs 3A can be passed through the diffusing region 32 to still more effectively diffuse that light over a wide area.

As described above, the transparent plate 30 disposed on the light source 3 elements, which are chip-type LEDs 3A, converges light emitted over a wide area by the chip-type LEDs 3A and transmits it to the outside through the converging regions 31. Further, the transparent plate 30 diffuses in various directions light emitted over a wide area by the chip-type LEDs 3A to shine light uniformly over an even wider area. As a result, the light source 3, which is a plurality of chip-type LEDs 3A arrayed on the circuit board 10, can shine light to the outside that is intense in the center region and is diffused uniformly over a wide area around the periphery.

The transparent plate 30 is shaped to fit the outline of the outer facing smooth surface inside the window 1 b in the second case 1 B, and the diffusing region 32 side is provided with a rim 34 around the outside that projects outward from the center of the transparent plate 30. As shown in Figs. 6 and 7, the rim 34 has an outline that is larger than the window 1 b in the second case 1 B. Guide rods 26 established around the window 1 b in the second case 1 B insert into through-holes 35 provided in the rim 34 around the perimeter of the transparent plate 30 to attach the transparent plate 30 in a fixed position.

Although the transparent plate 30 described above is provided with converging regions 31 and a diffusing region 32, converging regions and a diffusing region are not necessarily required. The transparent plate can also be made with no converging regions to transmit light without convergence, or the transparent plate can be made entirely as a diffusing region to diffuse light over an even wider area. Further, the indented surface structure of the converging regions and diffusing region is in no way limited to the structure described above. The converging regions can be any configuration that converges and transmits light, and the diffusing region can be any configuration that diffuses transmitted light in various directions.

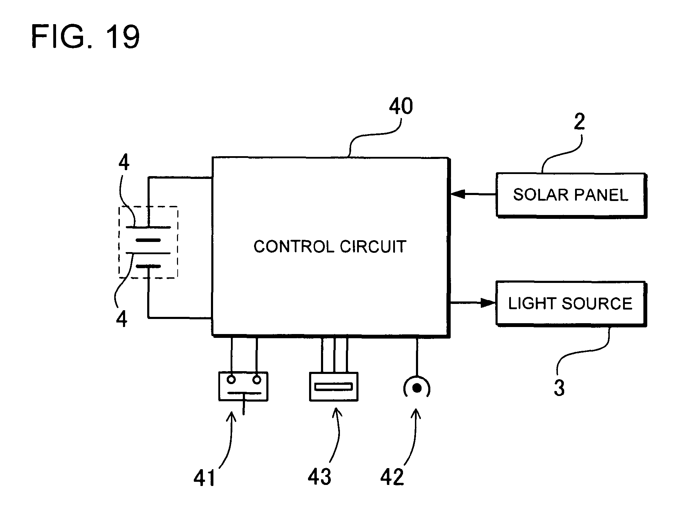

Turning to Fig. 19, a block diagram of the portable light circuitry is shown. This portable light is provided with a solar panel 2, batteries 4 that can be charged, a control circuit 40, and a light source 3. The control circuit 40 is connected to the light switch 41. Further, the solar panel 2, an input connector 42, and an output connector 43 are connected to the control circuit 40 of the portable light of the figure.

The input connector 42 and output connector 43 are disposed inside a cavity established in the battery compartment 6 standing surface 7, which is the bottom surface of the outer case 1. When the input connector 42 and the output connector 43 are not in use, the cavity in the battery compartment 6 is closed-off by a removable cover. An AC adapter (not illustrated) is connected to the input connector 42 to supply power to charge the batteries 4. The output connector 43 can connect to a universal serial bus (USB) connector on a USB cable, and battery 4 power can be converted to a specified voltage by the control circuit 40 for output via the USB connector.

The control circuit 40 charges the batteries 4 with power from the solar panel 2, detects full-charge, and terminates battery 4 charging when the batteries 4 are fully-charged. When an AC adapter is connected to the input connector 42, the batteries 4 are charged by power input from the AC adapter. In that case as well, the control circuit 40 terminates charging when the batteries 4 become fully-charged. In addition, when the light switch 41 is operated, the control circuit 40 supplies power from the batteries 4 to the light source to illuminate the light source and shine light to the outside. When the batteries discharge and the remaining capacity drops to or below a set capacity, the control circuit stops supplying power to the light source. Further, when the output connector 43 is connected to an external device via a USB connector, the control circuit 40 converts battery 4 power to a specified voltage and outputs that power from the output connector 43. In that case as well, when the remaining capacity of the batteries 4 drops to or below a set capacity, the control circuit stops supplying power.

The control circuit 40 also changes light source 3 activation according to ON signals input from the push-button light switch 41. For example, light source 3 illumination can be changed in the following order each time the light switch 41 is pressed: all three light source 3 LEDs 3A are illuminated; one light source 3 LED 3A is illuminated, and the light source 3 is powered OFF.

Finally, the portable light described above is provided with through-holes 27 located in the two upper-half corners of the outer case 1. A string can be passed through the through-holes 27 and tied together allowing the portable light to be carried over the shoulder or around the neck. Or, the string can be used to hang the portable light indoors or outdoors. It should be apparent to those with an ordinary skill in the art that while various preferred embodiments of the invention have been shown and described, it is contemplated that the invention is not limited to the particular embodiments disclosed, which are deemed to be merely illustrative of the inventive concepts and should not be interpreted as limiting the scope of the invention, and which are suitable for all modifications and changes falling within the spirit and scope of the invention as defined in the appended claims.

## Claims

1. A portable light comprising:
an outer case (1);
batteries (4) that can be charged and are housed inside the outer case (1);
a solar panel (2) that charges the batteries (4); and
a light source (3) illuminated by power from the batteries (4);
**characterized in that**
the outer case (1) is provided with a flat-panel section (5) that contains the solar panel (2) and light source (3); and a battery compartment (6) that is thicker than the flat-panel section (5), is established protruding outward from the bottom edge of a flat-panel section (5) surface, and has a bottom standing surface (7) enabling the flat-panel section (5) to stand upright on its own.

2. The portable light as cited in claim 1 wherein the standing surface (7) stands the flat-panel section (5) with the solar panel (2) surface inclined at an angle greater than a right angle with respect to horizontal and with the light source (3) surface inclined at an angle less than a right angle with respect to horizontal.

3. The portable light as cited in claim 1 wherein a circuit board (10) is housed inside the flat-panel section (5); the circuit board (10) has solar cells (20) that make up the solar panel (2) disposed on a first surface (11), and the light source (3) disposed on a second surface (12) on the side opposite the first surface (11); and the circuit board (10) is housed in the outer case (1) with the first surface (11) and the second surface (12) laminated in a water-tight configuration with light-transparent film layers (8).

4. The portable light as cited in claim 3 wherein the light-transparent film layers (8) are laminated on the circuit board (10) in a manner establishing exposed regions (13) around the perimeter, and the exposed regions (13) are sandwiched by the outer case (1) to hold the circuit board (10) in a fixed position inside the outer case (1).

5. The portable light as cited in claim 4 wherein sections of the perimeter of the circuit board (10) are provided with escape regions (8X) that allow the light-transparent film layers (8) to extend beyond the outer edge of the circuit board (10).

6. The portable light as cited in any one of the claims 3-5 wherein the light-transparent film layers (8) are ethylene vinyl acetate (EVA).

7. The portable light as cited in any one of the claims 3-6 wherein a light source (3) of light emitting diodes (LEDs) (3A) and electronic components (36) are mounted on the second surface (12) of the circuit board (10), and the LEDs (3A) and electronic components (36) are laminated with light-transparent film (8) to form a water-tight structure.
